(19) **Europäisches Patentamt**
**European Patent Office**
**Office européen des brevets**

(11) **EP 1 784 870 B1**

(12) **EUROPÄISCHE PATENTSCHRIFT**

(45) Veröffentlichungstag und Bekanntmachung des Hinweises auf die Patenterteilung:
**02.04.2008 Patentblatt 2008/14**

(21) Anmeldenummer: **05761201.2**

(22) Anmeldetag: **15.07.2005**

(51) Int Cl.:
*H01L 31/0248* (2006.01)   *H01L 31/0352* (2006.01)
*H01L 31/068* (2006.01)   *H01L 33/00* (2006.01)

(86) Internationale Anmeldenummer:
**PCT/EP2005/007711**

(87) Internationale Veröffentlichungsnummer:
**WO 2006/008080 (26.01.2006 Gazette 2006/04)**

(54) **HALBLEITERBAUELEMENT MIT EINEM AUF MINDESTENS EINER OBERFLÄCHE ANGEORDNETEN ELEKTRISCHEN KONTAKT**

SEMICONDUCTOR ELEMENT WITH AN ELECTRIC CONTACT ARRANGED ON AT LEAST ONE SURFACE

COMPOSANT SEMI-CONDUCTEUR POURVU D'UN CONTACT ELECTRIQUE SITUE SUR AU MOINS UNE SURFACE

(84) Benannte Vertragsstaaten:
**BE DE ES FR NL**

(30) Priorität: **16.07.2004   DE 102004034435**

(43) Veröffentlichungstag der Anmeldung:
**16.05.2007   Patentblatt 2007/20**

(73) Patentinhaber:
- **Fraunhofer-Gesellschaft zur Förderung der angewandten Forschung e.V.
  80686 München (DE)**
- **Albert-Ludwigs-Universität Freiburg
  79098 Freiburg (DE)**

(72) Erfinder:
- **METTE, Ansgar
  79106 Freiburg (DE)**
- **GLUNZ, Stephan
  79111 Freiburg (DE)**
- **PREU, Ralf
  79117 Freiburg (DE)**
- **SCHETTER, Christian
  79098 Freiburg (DE)**

(56) Entgegenhaltungen:
**EP-A- 1 182 709        US-A- 4 379 944
US-A- 6 084 175**

- **FATH P ET AL: "Highly efficient crystalline silicon solar cells using a novel shallow angle metallization (SAM) technique" 25TH PVSC, 13. Mai 1996 (1996-05-13), Seiten 525-528, XP010208204 Washington D.C.**
- **TOBIN S P ET AL: "Experimental comparison of light-trapping structures for silicon solar cells" CONFERENCE RECORD OF THE TWENTIETH IEEE PHOTOVOLTAIC SPECIALISTS CONFERENCE, 26. September 1988 (1988-09-26), Seiten 545-548, XP010750468 New York**

EP 1 784 870 B1

**Beschreibung**

Die Erfindung betrifft ein Halbleiterbauelement mit einem auf mindestens einer Oberfläche angeordneten elektrischen Kontakt, bei welchem über diese Oberfläche sowohl elektrische als auch optische Leistung in das Halbleiterbauelement ein- und/oder auskoppelbar ist. Insbesondere betrifft die Erfindung eine Solarzelle oder eine Hochleistungs-Leuchtdiode.

Halbleiterbauelemente mit hohen Leistungsdichten werden von großen Strömen durchflossen. Um diese Ströme verlustarm der aktiven Halbleiterschicht zu- oder abzuführen sind große Leiterquerschnitte erforderlich. Oft werden hierzu großflächige Metallkontakte an der Halbleiteroberfläche angebracht. Bei optoelektronischen Halbleiterbauelementen stellt sich jedoch das zusätzliche Problem, dass von einer Oberfläche der Bauelemente auch Licht ein- oder ausgekoppelt werden muss. Somit können die Leiterstrukturen auf dieser Oberfläche nicht vollflächig ausgeführt werden.

Um dennoch große Leiterquerschnitte zu erhalten, wird angestrebt, eine streifenförmige Metallisierung auf das Bauelement aufzubringen, welche eine geringe Breite bei gleichzeitig großer Höhe bzw. Dicke zur Erhöhung des Leiterquerschnitts aufweist. Somit ist es möglich, gleichzeitig hohe Ströme verlustarm über die Halbleiteroberfläche zu- bzw. abzuleiten und über die unbedeckten Oberflächenbereiche Licht ein- bzw. auszukoppeln.

Um die beschriebenen Kontaktstrukturen zu erzeugen, sind verschiedene Verfahren gebräuchlich. Diese können entweder der Dickfilm- oder der Dünnfilmtechnologie zugerechnet werden. Bei der Dickfilmtechnologie wird eine metallhaltige Paste in einem Druckschritt auf die Oberfläche aufgebracht und in einem nachfolgenden Hochtemperaturschritt mit der Oberfläche verbunden und zu einer Leiterbahn gesintert. Das Aufbringen der metallhaltigen Paste kann dabei entweder im Siebdruckverfahren, im Tampondruckverfahren oder durch Pastenschreiben erfolgen. Die kleinste erreichbare Strukturbreite beträgt dabei 50-80 $\mu$m bei einer maximalen Schichtdicke von etwa 10 $\mu$m.

Zu den Dünnfilmverfahren zählt beispielsweise die Photolithographie. In diesem Fall wird das zu metallisierende Substrat mit einem Fotolack beschichtet, welcher durch Belichtung und Entwicklung strukturiert wird. Durch Aufdampfen oder Sputtern einer oder mehrerer Metallschichten werden dann die Metallkontakte in den vorbestimmten Raumbereichen aufgebracht. Da in diesem Fall die maximal mögliche Dicke der Metallisierung durch die Dicke des Fotolacks limitiert ist, besteht in der Regel eine absolute Grenze der Schichtdicke von etwa 10 $\mu$m.

Weiterhin ist bekannt, durch nachfolgendes Verzinnen der Leiterbahnen das Höhen- zu Breitenverhältnis zu verbessern. So wird beispielsweise beim Verzinnen eines photolithographisch hergestellten Leiters von 10 $\mu$m Dicke und 193 $\mu$m Breite bei einem Benetzungswinkel von 45° des flüssigen Zinns ein Höhen- zu Breitenverhältnis von 0,26 erreicht. Die unverzinnte Leiterbahn weist demgegenüber ein Verhältnis von 0,05 auf.

Mit allen vorbezeichneten Metallisierungsverfahren sind große Höhen- zu Breitenverhältnisse, d.h. Werte um oder über 1 nicht erzielbar. Darüber hinaus umfassen alle genannten Verfahren mehrere Prozessschritte und sind daher in der industriellen Massenfertigung kostenaufwändig und fehleranfällig.

Die US 5,468,652 offenbart eine Solarzelle, bei welcher die Abschattung der Vorderseite dadurch verhindert wird, dass Löcher im Substrat vorgesehen werden, durch welche die Oberseite kontaktiert werden kann. Nachteilig an dieser Solarzelle ist die Tatsache, dass dieses Verfahren viele Prozessschritte beinhaltet und für eine industrielle Fertigung zu aufwändig ist.

Das Dokument von P. Fath et al., 25TH PVSC, 13. Mai 1996, Seiten 525-528, beschreibt eine solarzelle aus Silizium und ein Herstellungsverfahren dazu.

Die EP 1 182 709 A1 offenbart ein Verfahren zur Herstellung von Metallkontakten, bei welchem auf der Vorderseite der Solarzelle Gräben angeordnet werden, welche einen Metallkontakt aufnehmen. Dazu wird zunächst eine oder mehrere Nuten in die Solarzellenoberseite eingebracht. Nachfolgend wird auf deren Innenseite eine Bekeimungsschicht durch außenstromlose Abscheidung und Sintern aufgebracht. In einem weiteren Verfahrensschritt wird eine Kontaktschicht auf der Bekeimungsschicht abgeschieden und der Graben mit Kupfer komplett aufgefüllt. Auf diese Weise können die Beschränkungen der beschriebenen Dickfilm- und Dünnfilm- Verfahren umgangen werden. Allerdings müssen die Gräben vor der Metallisierung dotiert werden. Dieser weitere Verfahrensschritt erhöht sowohl die Kosten als auch die Fehleranfälligkeit des Verfahrens und verringert die aktive Schichtdicke des Halbleitermaterials.

Die Aufgabe der vorliegenden Erfindung besteht demnach darin, ein Halbleiterbauelement nach Anspruch 1 und ein Verfahren nach Anspruch 14 zu dessen Herstellung anzugeben, bei welchem mit wenigen Prozessschritten in einfacher Weise Metallkontakte auf Halbleiteroberflächen erzeugt werden können, welche sich durch einen großen Leiterquerschnitt und geringe Abschattung auszeichnen. Insbesondere sollen Kontaktstrukturen erzeugt werden, welche ein Höhen- zu Breitenverhältnis von etwa 1 aufweisen.

Die Aufgabe wird erfindungsgemäß gelöst durch ein Halbleiterbauelement nach Anspruch 1. Weiterhin besteht die Lösung der Aufgabe in einem Verfahren zur Herstellung eines Halbleiterbauelementes nach Anspruch 14. Somit ist bei dem erfindungsgemäßen Kontakt das Höhen- zu Breitenverhältnis im Vergleich zu den flachen Kontakten nach dem Stand der Technik erheblich vergrößert. Die Ausbildung des erfindungsgemäßen Kontaktes bei der galvanischen oder außenstromlosen Abscheidung beruht einerseits darauf, dass die Feldstärke an der Oberfläche spitzer Strukturen eine Überhöhung zeigt. Somit werden sich Metallionen aus einem Galvanik-Bad bevorzugt an diesen spitzen Strukturen bzw. Kanten abscheiden.

Weiterhin nutzt das erfindungsgemäße Herstellungsverfahren den inneren Fotoeffekt eines photovoltaischen Bauelementes aus. Unter dem inneren Fotoeffekt wird hier die räumliche Trennung von positiven und negativen Ladungsträgern unter Lichteinfall in einem pn-Übergang verstanden. Erfindungsgemäß wurde erkannt, dass sich Metallionen aus einem Abscheidebad unter Lichteinfall bevorzugt entlang der Kante anlagern. Dieser Effekt tritt dann auf, wenn die eingestrahlten Photonen eine Energie oberhalb der Bandlückenenergie aufweisen. Beispielsweise eignet sich zur Beleuchtung ein Laser oder eine Leuchtdiode. Eine besonders einfache Lichtquelle stellt eine handelsübliche Halogenlampe dar.

Eine zur Aufnahme eines Kontaktes vorgesehene Kante kann beispielsweise dadurch ausgebildet werden, dass in die Oberfläche des Halbleitersubstrates ein Graben eingebracht wird. Auf diese Weise lassen sich Anzahl, Größe und Art der Metallkontakte auf der Oberfläche beliebig festlegen. Da der Metallkontakt lediglich an der Kante des Grabens angeordnet ist, kann die nicht vom Kontakt bedeckte Fläche weiterhin als Ein- bzw. Austrittsfläche für Photonen benutzt werden.

Der eingebrachte Graben kann dabei einen beliebigen Querschnitt aufweisen. Beispielsweise wären hier rechteckige, quadratische oder unregelmäßig geformte Querschnitte denkbar. Besonders bevorzugt ist jedoch ein U- bzw. V-förmiger Graben. Der V-förmige Graben weist dabei einen dreiecksförmigen Querschnitt auf. Beim U-förmigen Graben handelt es sich um einen Querschnitt, welcher an seiner tiefsten, d.h. der am weitesten von der Oberfläche entfernten, Stelle einen runden Querschnitt aufweist, die Seitenflächen können demgegenüber senkrecht oder schräg angeordnet werden. Insbesondere der V-förmige Graben zeichnet sich dadurch aus, dass auf die Oberfläche auftreffendes Licht besonders effizient in den Halbleiter eingekoppelt wird.

Eine ganz besonders bevorzugte Ausführung ist dadurch gekennzeichnet, dass sich zwei U- oder V-förmige Gräben teilweise überlappen, so dass sich an deren Berührungslinie eine scharfe Kante ausbildet. Der daraus resultierende Graben weist demnach einen W-förmigen Querschnitt auf, wobei der erfindungsgemäße Kontakt an der mittleren Spitze des W-förmigen Grabens gebildet wird. Durch diese geometrische Ausgestaltung der Kontaktzone wird eine besonders scharfe Kante erreicht, welche durch eine große Feldüberhöhung die Herstellung des erfindungsgemäßen Kontaktes erleichtert.

Erfindungsgemäß werden die Gräben durch spanende Bearbeitung oder durch Ätzen oder durch Laserablation gefertigt. Für die spanende Bearbeitung wird der Fachmann Sägen, Fräsen oder Schleifen in Betracht ziehen. Ätzen kann sowohl nass- als auch trockenchemisch erfolgen.

In einer bevorzugten Ausführungsform weist die Kante einen Winkel von etwa 5° bis etwa 120° auf, besonders bevorzugt etwa 45° bis etwa 65°. Es hat sich gezeigt, dass in diesem Winkelbereich sowohl die Herstellung der Kante in einfacher Weise möglich ist, als auch die Feldüberhöhung zur Herstellung des Kontaktes ausreicht. Die Tiefe des. Grabens beträgt dabei bevorzugt etwa 1 $\mu$m bis etwa 100 $\mu$m, besonders bevorzugt etwa 20 $\mu$m bis etwa 50 $\mu$m. Dieser Bereich ist dadurch begründet, dass einerseits bei flacheren Grabenstrukturen keine ausreichende Feldüberhöhung auftritt, andererseits bei tieferen Strukturen die Stabilität des Bauelementes nachteilig beeinträchtigt wird.

Durch den Elektronenüberschuss auf einer n-dotierten Halbleiterschicht scheiden sich Metallionen aus der wässrigen Lösung ab und bilden einen elektrischen Kontakt. Es hat sich herausgestellt, dass insbesondere n-dotierte Schichten mit einem spezifischen Widerstand von 30 Ω/sq bis 140 Ω/sq mit dem erfindungsgemäßen Verfahren kontaktierbar sind. Die SI-Darstellung der Einheit Ω/sq lautet dabei $\frac{V}{A} \cdot \frac{cm}{cm}$ und ist dem Fachmann zur Angabe des spezifischen Widerstandes einer Emitterschicht geläufig. Besonders bevorzugt kann das Verfahren zur Metallisierung einer n-dotierten Emitterschicht einer Solarzelle eingesetzt werden.

Obgleich mit dem erfindungsgemäßen Verfahren sowohl Ohmsche als auch Schottky-Kontakte herstellbar sind, eignet sich das Verfahren insbesondere für die Herstellung niederohmiger Kontakte auf Leistungshalbleitern wie beispielsweise Solarzellen oder Hochleistungs-Leuchtdioden. Der erfindungsgemäße Kontakt kann auf Element- oder Verbindungshalbleitern ausgeführt werden. Insbesondere eignet sich der Kontakt für die Kontaktierung von Halbleiterbauelementen auf Siliciumsubstraten.

In Abhängigkeit des verwendeten Halbleitermaterials wird der Fachmann zur Herstellung des Kontaktes insbesondere Nickel und/oder Silber und/oder Zinn und/oder Titan und/oder Aluminium und/oder Palladium und/oder Kupfer und/oder Chrom in Betracht ziehen. Insbesondere wird der Fachmann auch Legierungen der genannten Metalle in Betracht ziehen.

Zur Verringerung des Übergangswiderstandes zwischen dem Metallkontakt und dem Halbleitermaterial wird in einer vorteilhaften Weiterbildung der Erfindung das Bauteil nach Abscheidung des metallischen Kontaktes bei einer Temperatur zwischen 660K und 740K, insbesondere bei einer Temperatur von 698K gesintert. Durch diesen Prozessschritt kommt es einerseits zur Legierungsbildung und damit zur Änderung der Austrittsarbeit innerhalb der Metallschicht, so dass die Schottky-Barriere bei richtiger Wahl der Zusammensetzung in Abhängigkeit des Halbleiter-Basismaterials weiter verringert wird. Darüber hinaus bewirkt der Sinterschritt eine Verbindung des Metalles mit dem darunter liegenden Halbleitermaterial bei gleichzeitiger Legierungsbildung im Übergangsbereich.

Einen besonders haftfesten Kontakt mit besonders niedrigem Übergangswiderstand bewirkt eine Ausgestaltung des Verfahrens, bei welcher die Kante vor Abscheidung des Kontaktes aufgeraut wird. Dieses Aufrauen kann entweder mechanisch durch Spanen mit geometrisch bestimmten oder unbestimmten Schneiden erfolgen und/oder durch Ätzen. Sofern ein Ätzschritt für die Aufrauung vorgesehen wird, wird der Fachmann selbstverständlich sowohl einen nasschemischen als auch einen trockenchemischen Ätzschritt in Betracht ziehen.

Nachfolgend soll die Erfindung anhand eines Ausführungsbeispiels und mehrerer Figuren näher erläutert werden.

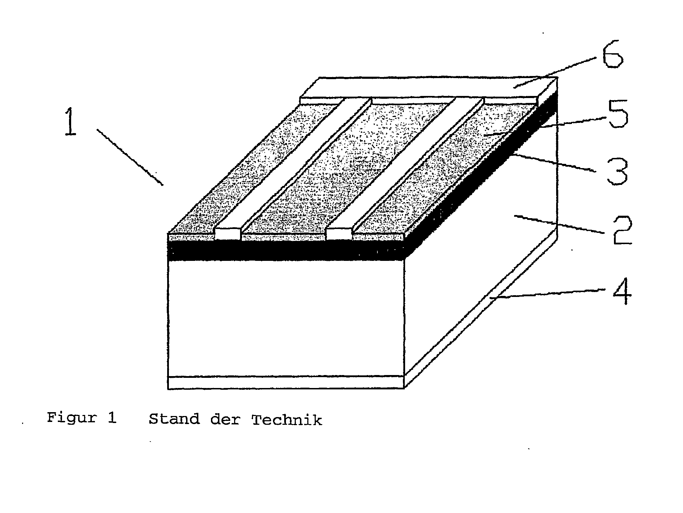

Fig. 1 zeigt eine Solarzelle nach dem Stand der Technik. Zu deren Herstellung wird auf ein p-dotiertes Siliziumsubstrat als Basisbereich ein flächiger Rückseitenkontakt 4 aufgebracht. Auf der gegenüberliegenden Seite erfolgt die Herstellung einer n-dotierten Emitterschicht 3. Zum Schutz vor Umwelteinflüssen und zur Erhöhung des optischen Wirkungsgrades wird auf die Solarzelle nach dem Stand der Technik eine Antireflexions- und Passivierungsschicht 5 aufgebracht. In vorbestimmten Raumbereichen, welche von der Antireflexions- und Passivierungsschicht ausgenommen sind, werden metallische Kontakte zur Ableitung des erzeugten Stromes aufgebracht. Diese Kontakte weisen typischerweise Breiten von 80-100 $\mu$m auf bei Dicken von weniger als 10 $\mu$m. Fallweise können diese Kontakte durch Verzinnen oder galvanische Abscheidung noch verstärkt werden.

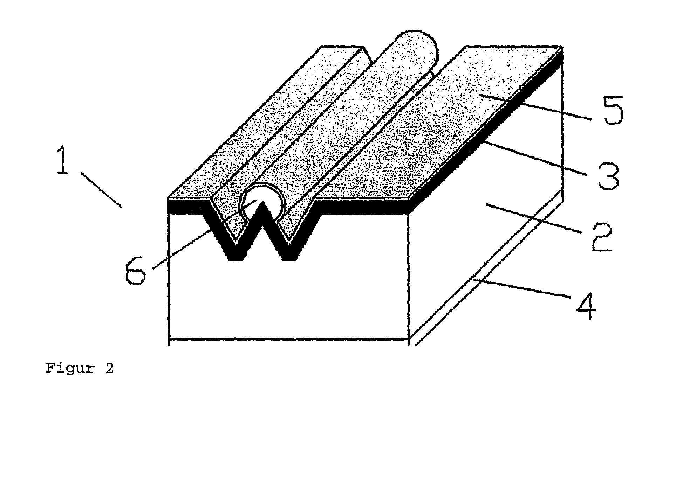

Fig.2 zeigt eine erfindungsgemäß hergestellte Solarzelle. Wiederum wird auf einem p-dotierten Basismaterial ein Rückseitenkontakt 4 aufgebracht. Die gegenüberliegende Seite wird durch spanende Bearbeitung mit einem feinen Sägeblatt mit V-förmigen Gräben überzogen. Die Schnittführung erfolgt dabei dergestalt, dass die V-förmigen Gräben teilweise überlappen und der Querschnitt der so erzeugten Gräben die Form eines 'W' annimmt. Durch einen Ätzschritt werden Sägeschäden an der Oberfläche egalisiert, Nach diesem Schritt weisen die Gräben eine Tiefe von 30$\mu$m auf und die mittlere Spitze zeigt einen Winkel von etwa 60°. Durch Co-Diffusion wird auf der so strukturierten Oberfläche ein niederohmiger Emitter 3 erzeugt.

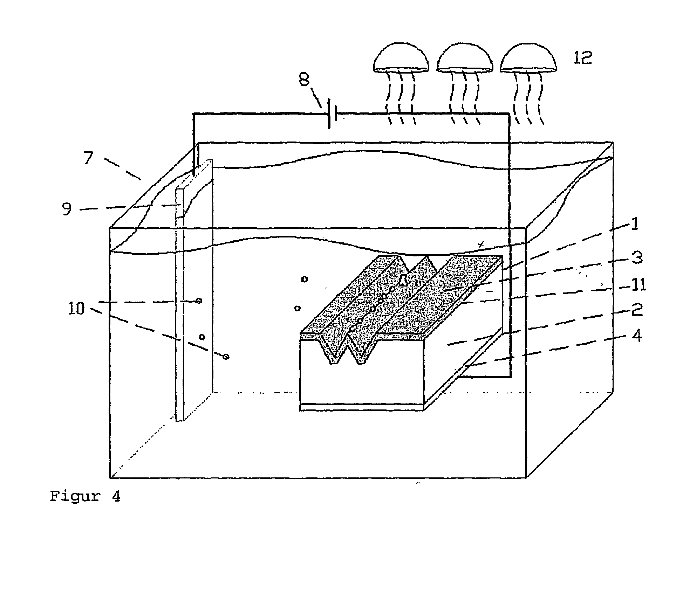

In Figur 4 ist dargestellt, wie der Wafer zur Bildung der Kontakte auf den Spitzen der W-förmigen Gräben in einem K(Ag(CN)$_2$)-haltigen Bad 7 einer galvanischen Abscheidung unterzogen wird. Hierzu wird der Wafer mit einer Stromdichte von 1A/dm$^2$ beaufschlagt, bei gleichzeitiger Bestrahlung durch Halogenlampen 12. Binnen einer Minute setzt sich eine geschlossene Silberschicht 6 an den Spitzen ab. Nach einem Sinterschritt bei 698K können die so ausgebildeten Kontakte 6 durch einen weiteren Galvanikschritt verstärkt werden. Die so hergestellten Kontakte haben einen im Wesentlichen runden Querschnitt und weisen demnach einen im Vergleich zum Stand der Technik verbessertes Höhen- zu Breitenverhältnis auf. Die nicht vom Kontakt belegten Flächen der W-förmigen Gräben sind ebenso wie die dazwischen liegenden ebenen Flächen als aktive, lichtabsorbierende Flächen wirksam. Die Strombelastbarkeit ist ebenso wie die Größe der lichtabsorbierenden Flächen erhöht.

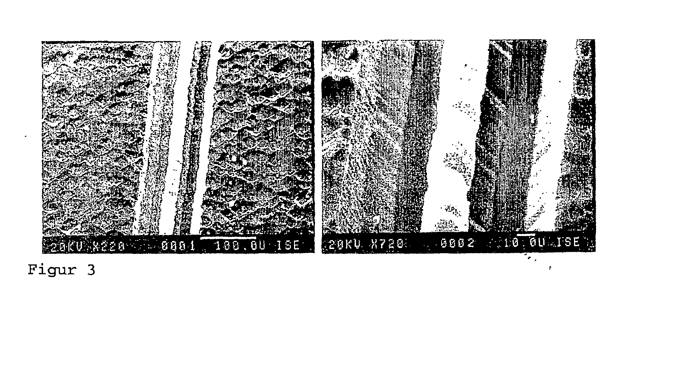

Figur 3 zeigt rasterelektronenmikroskopische Aufnahmen des erfindungsgemäßen Halbleiterkontaktes. Deutlich erkennbar sind im mittleren Bildteil die beiden V-förmigen Gräben, an deren innerer Berührungslinie der Metallkontakt aufgebracht ist.

## Patentansprüche

1. Halbleiterbauelement (1) mit einem auf mindestens einer Oberfläche angeordneten elektrischen Kontakt, bei welchem über diese Oberfläche sowohl elektrische als auch optische Leistung in das Halbleiterbauelement ein- und/oder auskoppelbar ist, **dadurch gekennzeichnet, dass** der Kontakt (6) an mindestens einer auf der Oberfläche angeordneten Kante angeordnet und' durch galvanische oder außenstromlose Abscheidung eines Metalls oder einer Legierung bei gleichzeitiger Einstrahlung von Licht erhältlich ist und die Kante durch mindestens einen in die Oberfläche eingebrachten Graben gebildet wird, wobei der Kontakt einen runden, die Kante umschließenden Querschnitt aufweist.

2. Halbleiterbauelement nach Anspruch 1, **dadurch gekennzeichnet, dass** die Kante durch die Berührungslinie zweier Gräben gebildet wird.

3. Halbleiterbauelement nach einem der Ansprüche 1 bis 2, **dadurch gekennzeichnet, dass** der oder die Gräben eine V- oder U-Form aufweisen.

4. Halbleiterbauelement nach einem der Ansprüche 1 bis 3, **dadurch gekennzeichnet, dass** die Kante einen Winkel von etwa 5° bis etwa 120° aufweist.

5. Halbleiterbauelement nach Anspruch 4, **dadurch gekennzeichnet, dass** die Kante einen Winkel von etwa 45° bis etwa 65°, insbesondere 60° aufweist.

6. Halbleiterbauelement nach einem der Ansprüche 1 bis 5, **dadurch gekennzeichnet, dass** die Tiefe eines einzelnen Grabens etwa 1 $\mu$m bis etwa 100 $\mu$m beträgt.

7. Halbleiterbauelement nach Anspruch 6, **dadurch gekennzeichnet, dass** die Tiefe eines einzelnen Grabens etwa 20 $\mu$m bis etwa 50 $\mu$m beträgt.

8. Halbleiterbauelement nach einem der Ansprüche 1 bis 7, **dadurch gekennzeichnet, dass** die Oberfläche des Halbleiterbauelementes durch eine n-dotierte Emitterschicht gebildet wird.

**9.** Halbleiterbauelement gemäß Anspruch 8, **dadurch gekennzeichnet, dass** die Emitterschicht einen spezifischen Widerstand von 30 Ohm/sq. bis 140 Ohm/sq. aufweist.

**10.** Halbleiterbauelement nach einem der Ansprüche 1 bis 9, **dadurch gekennzeichnet, dass** der Kontakt ein ohmscher Kontakt ist.

**11.** Halbleiterbauelement nach einem der Ansprüche 1 bis 10, **dadurch gekennzeichnet, dass** der Kontakt Ni und/oder Ag und/oder Sn und/oder Ti und/oder Al und/oder Pd und/oder Cu und/oder Cr enthält.

**12.** Halbleiterbauelement nach einem der Ansprüche 1 bis 11, **dadurch gekennzeichnet, dass** es aus einem Basismaterial hergestellt ist, welches Silicium enthält.

**13.** Halbleiterbauelement nach einem der Ansprüche 1 bis 12, **dadurch gekennzeichnet, dass** es eine Solarzelle umfasst .

**14.** Verfahren zur Herstellung eines Halbleiterbauelementes (1) **gekennzeichnet durch**:

• Ausbilden einer Kante an einer Oberfläche des Halbleiters **durch** Einbringen von mindestens einem Graben
• galvanisches oder außenstromloses Abscheiden eines Kontaktes (6) an der Kante bei gleichzeitiger Einstrahlung von Licht, mit einer dazu bereitgestellten Lichtquelle.

**15.** Verfahren nach Anspruch 14, **dadurch gekennzeichnet, dass** die Bestrahlung mit Licht erfolgt, dessen Photonenenergie größer oder gleich der Bandlücke des Halbleitermaterials ist.

**16.** Verfahren nach einem der Ansprüche 14 oder 15, **dadurch gekennzeichnet, dass** der Kontakt nach der galvanischen oder außenstromlosen Abscheidung gesintert wird.

**17.** Verfahren nach Anspruch 16, **dadurch gekennzeichnet, dass** das Bauteil bei einer Temperatur zwischen 660K und 740K, insbesondere 698K gesintert wird.

**18.** Verfahren nach einem der Ansprüche 14 bis 17, **dadurch gekennzeichnet, dass** die mindestens eine Kante durch Einbringen von zwei Gräben ausgebildet wird, welche teilweise überlappen

**19.** Verfahren nach einem der Ansprüche 14 bis 18, **dadurch gekennzeichnet, dass** die Kante durch Laserstrahlung, durch Plasmaeinwirkung oder durch spanende Bearbeitung erzeugt wird.

**20.** Verfahren nach einem der Ansprüche 14 bis 19, **dadurch gekennzeichnet, dass** die Kante mechanisch und/oder durch Ätzen aufgeraut wird.

**21.** Verfahren nach einem der Ansprüche 14 bis 20, **dadurch gekennzeichnet, dass** der Kontakt durch galvanische oder außenstromlose Abscheidung von Ni und/oder Ag und/oder Sn und/oder Ti und/oder Al und/oder Pd und/oder Cu und/oder Cr hergestellt wird.

**22.** Verfahren nach einem der Ansprüche 14 bis 21, **dadurch gekennzeichnet, dass** die Einstrahlung von Licht mittels Halogenleuchten erfolgt.

**23.** Verwendung des Verfahrens nach einem der Ansprüche 14 bis 22 zur Herstellung von Solarzellen.

**Claims**

**1.** Semiconductor component (1) with an electric contact arranged on at least one surface, with which electric as well as optical power can be introduced into the semiconductor component and/or decoupled therefrom via this surface, **characterized in that** the contact (6) is arranged on at least one edge arranged on the surface and can be obtained by the galvanic or electroless deposition of a metal or of an alloy with the simultaneous irradiation of light, and the edge is formed by at least one trench made in the surface, whereby the contact has a round cross section surrounding the edge.

**2.** Semiconductor component according to claim 1, **characterized in that** the edge is formed by the contact line of two trenches.

**3.** Semiconductor component according to one of claims 1 through 2, **characterized in that** the trench or the trenches have a V-shape or a U-shape.

**4.** Semiconductor component according to one of claims 1 through 3, **characterized in that** the edge has an angle of approx. 5° to approx. 120°.

**5.** Semiconductor component according to claim 4, **characterized in that** the edge has an angle of approx. 45° to approx. 65°, in particular 60°.

**6.** Semiconductor component according to one of claims 1 through 5, **characterized in that** the depth of an individual trench is approx. 1 $\mu$m to approx. 100 $\mu$m.

**7.** Semiconductor component according to claim 6, **characterized in that** the depth of an individual trench is approx. 20 $\mu$m to approx. 50 $\mu$m.

8. Semiconductor component according to one of claims 1 through 7, **characterized in that** the surface of the semiconductor component is formed by an n-doped emitter layer.

9. Semiconductor component according to claim 8, **characterized in that** the emitter layer has a specific resistance of 30 ohm/sq. to 140 ohm/sq.

10. Semiconductor component according to one of claims 1 through 9, **characterized in that** the contact is an ohmic contact.

11. Semiconductor component according to one of claims 1 through 10, **characterized in that** the contact contains Ni and/or Ag and/or Sn and/or Ti and/or Al and/or Pd and/or Cu and/or Cr.

12. Semiconductor component according to one of claims 1 through 11, **characterized in that** it is produced from a base material that contains silicon.

13. Semiconductor component according to one of claims 1 through 12, **characterized in that** it comprises a solar cell.

14. Method for producing a semiconductor component (1), **characterized by**:

   • The embodiment of an edge on a surface of the semiconductor by making at least one trench
   • Galvanic or electroless deposition of a contact (6) on the edge with the simultaneous irradiation with light using a light source provided for that purpose.

15. Method according to claim 14, **characterized in that** the irradiation occurs with light, the photon energy of which is greater than or equal to the bandgap of the semiconductor material.

16. Method according to one of claims 14 or 15, **characterized in that** the contact is sintered after the galvanic or electroless deposition.

17. Method according to claim 16, **characterized in that** the component is sintered at a temperature between 660K and 740K, in particular 698K.

18. Method according to one of claims 14 through 17, **characterized in that** the at least one edge is embodied by making two trenches that partially overlap.

19. Method according to one of claims 14 through 18, **characterized in that** the edge is produced by laser radiation, by plasma action or by machining.

20. Method according to one of claims 14 through 19, **characterized in that** the edge is roughened mechanically and/or by etching.

21. Method according to one of claims 14 through 20, **characterized in that** the contact is produced by galvanic or electroless deposition of Ni and/or Ag and/or Sn and/or Ti and/or Al and/or Pd and/or Cu and/or Cr.

22. Method according to one of claims 14 through 21, **characterized in that** the irradiation of light is carried out by means of halogen lamps.

23. Use of the method according to one of claims 14 through 22 to produce solar cells.

## Revendications

1. Composant à semi-conducteurs (1) avec un contact électrique disposé sur au moins une surface, sur lequel, par l'intermédiaire de ladite surface, aussi bien une puissance électrique qu'une puissance optique est susceptible d'être injectée dans le composant à semi-conducteurs ou extraite de ce dernier, **caractérisé en ce que**, le contact (16) est disposée sur au moins une arête disposée sur la surface et peut être obtenu par déposition galvanique ou sans courant extérieur d'un métal ou d'un alliage, par irradiation simultanée de lumière et **en ce que** l'arête est formée par au moins une tranchée ménagée dans la surface, le contact présentant une section transversale ronde, entourant l'arête.

2. Composant à semi-conducteurs selon la revendication 1, **caractérisé en ce que** l'arête est formée par la ligne de contact de deux tranchées.

3. Composant à semi-conducteurs selon l'une quelconque des revendications 1 à 2, **caractérisé en ce que** la ou les tranchées présente(nt) la forme d'un V ou d'un U.

4. Composant à semi-conducteurs selon l'une quelconque des revendications 1 à 3, **caractérisé en ce que** l'arête présente un angle d'environ 5° à 120°.

5. Composant à semi-conducteurs selon la revendication 4, **caractérisé en ce que** l'arête présente un angle d'environ 45° à environ 65°, notamment de 60°.

6. Composant à semi-conducteurs selon l'une quelconque des revendications 1 à 5, **caractérisé en ce que** la profondeur d'une tranchée individuelle s'élève à de environ 1 $\mu$m à environ 100 $\mu$m.

7. Composant à semi-conducteurs selon la revendication 6, **caractérisé en ce que** la profondeur d'une tranchée individuelle s'élève à de environ 20 μm à environ 50 μm.

8. Composant à semi-conducteurs selon l'une quelconque des revendications 1 à 7, **caractérisé en ce que** la surface du composant à semi-conducteur est formée par une couche émettrice à dopage n.

9. Composant à semi-conducteurs selon la revendication 8, **caractérisé en ce que** la couche émettrice présente une résistance spécifique de 30 Ohm/sq. à 140 Ohm/sq.

10. Composant à semi-conducteurs selon l'une quelconque des revendications 1 à 9, **caractérisé en ce que** le contact est un contact ohmique.

11. Composant à semi-conducteurs selon l'une quelconque des revendications 1 à 10, **caractérisé en ce que** le contact contient du Ni et/ou de l'Ag et/ou du Sn et/ou du Ti et/ou de l'Al et/ou du Pd et/ou du Cu et/ou du Cr.

12. Composant à semi-conducteurs selon l'une quelconque des revendications 1 à 11, **caractérisé en ce qu'**il est fabriqué dans une matière de base contenant du silicium.

13. Composant à semi-conducteurs selon l'une quelconque des revendications 1 à 12, **caractérisé en ce qu'**il comprend une cellule solaire.

14. Procédé de fabrication d'un composant à semi-conducteurs (1), **caractérisé par**

    - la création d'une arête sur une surface du semi-conducteur par ménagement d'au moins une tranchée
    - la déposition galvanique ou sans courant extérieur d'un contact (6) sur l'arête sous irradiation simultanée de lumière, avec une source lumineuse mise à disposition à cet effet.

15. Procédé selon la revendication 14, **caractérisé en ce que** l'irradiation s'effectue avec de la lumière dont l'énergie photonique est supérieure ou égale à l'écart énergétique de la matière des semi-conducteurs.

16. Procédé selon l'une quelconque des revendications 14 ou 15, **caractérisé en ce qu'**on fritte le contact après la déposition galvanique ou sans courant extérieur.

17. Procédé selon la revendication 16, **caractérisé en ce qu'**on fritte le composant à une température comprise entre 660K et 740K, notamment de 698K.

18. Procédé selon l'une quelconque des revendications 14 à 17, **caractérisé en ce que** la au moins une arête est formée par ménagement de deux tranchées, qui se chevauchent partiellement.

19. Procédé selon l'une quelconque des revendications 14 à 18, **caractérisé en ce que** l'arête est créée par rayonnement laser, par influence de plasma ou par usinage par enlèvement de copeaux.

20. Procédé selon l'une quelconque des revendications 14 à 19, **caractérisé en ce qu'**on strie l'arête par voie mécanique et/ou par morsure.

21. Procédé selon l'une quelconque des revendications 14 à 20, **caractérisé en ce qu'**on fabrique le contact par déposition galvanique ou sans courant extérieur de Ni et/ou d'Ag et/ou de Sn et/ou de Ti et/ou d'Al et/ou de Pd et/ou de Cu et/ou de Cr.

22. Procédé selon l'une quelconque des revendications 14 à 21, **caractérisé en ce que** l'irradiation de lumière s'effectue au moyen de lampes halogènes.

23. Utilisation du procédé selon l'une quelconque des revendications 14 à 22 pour la fabrication de cellules solaires.

Figur 1    Stand der Technik

Figur 2

Figur 3

Figur 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 5468652 A

- EP 1182709 A1

### In der Beschreibung aufgeführte Nicht-Patentliteratur

- **VON P. FATH et al.** *25TH PVSC,* 13. Mai 1996, 525-528